# EUROPEAN PATENT APPLICATION

(11) **EP 1 372 191 A2**
(43) Date of publication of application: **17.12.2003**
(21) Application number: 03253753.2
(22) Date of filing: 12.06.2003
(51) Int. Cl.: H01L 21/768, H01L 21/027

(54) **Method for depositing a device feature on a substrate**

(30) Priority: 14.06.2002 GB 0213695
(71) Applicant: Filtronic Compound Semiconductor Limited, Newton Ayecliffe, Co. Durham, DL5 6JW (GB)
(72) Inventor: Phillips, Carl Christopher, Filtronic Compound, Newton Aycliffe, Co. Durham DL5 6JW (GB)
(74) Representative: McDonough, Jonathan

(57) **Abstract**

A method for depositing a feature on a substrate during a device fabrication process, the method comprising the steps of
providing a substrate;
providing a covering layer on the substrate;
providing a surface inhibition layer on the substrate;
providing an aperture extending through the surface inhibition layer;
providing a via extending from the aperture through the covering layer to the substrate, the via being larger then the aperture such that the surface inhibition layer overhangs the via;
depositing a feature material through the aperture onto the substrate to form the feature.

## Description

The present invention relates to solid state electronic device fabrication, and in particular to a method for improving lift off operations.

Solid state electronic devices tend to have very intricate and complex structures, such as conducting tracks, which are provided on a very fine scale and may need to be close to one another. In order to ensure the correct operation of a device it is important the parts of the device are as defect free as possible.

Multiple devices tend to be fabricated at the same time on a single wafer and owing to the manufacturing costs involved it is important to try and ensure that the yield of correctly functioning devices from a single wafer is as high as possible. Some current device fabrication processes use a method of fabricating features of devices which tends also to produce feature defects. Therefore a method which reduces such defects would be beneficial.

According to a first aspect of the invention there is provided a method for depositing a feature on a substrate during a device fabrication process, the method comprising the steps of
providing a substrate;
providing a covering layer on the substrate;
providing a surface inhibition layer on the substrate;
providing an aperture extending through the surface inhibition layer;
providing a via extending from the aperture through the covering layer to the substrate, the via being larger than the aperture such that the surface inhibition layer overhangs the via;
depositing a feature material through the aperture onto the substrate to form the feature.

As the aperture of the layer through which material is deposited is smaller than the region in which the feature is created, and as defined by the layer sidewalls, deposited material is not deposited on the sidewalls of the layer and so feature defects are avoided.

The covering layer can be a photoresist.

The step of providing a surface inhibition layer can comprise the steps of applying a developer to the top surface of the covering layer remote from the substrate; and subsequently heating the covering layer.

Preferably the steps of providing the aperture and the via comprise the steps of:
providing a mask;
irradiating the surface inhibition layer through an aperture in the mask;
applying a developer to remove the irradiated portion of the surface inhibition layer to define the aperture and to remove the covering layer to define the via, the developer having a lower dissolution rate in the surface inhibition layer than in the covering layer.

Preferably the via extends through the covering layer substantially normal to the substrate, the via being of uniform cross section along its length.

Preferably at least one lateral dimension of the aperture is less then the corresponding lateral dimension of the via.

In a further aspect of the invention there is provided a method for depositing a feature on a substrate during a device fabrication process, the method comprising the steps of:
providing a substrate;
proving a covering layer on the substrate, the covering layer having a via extending therethrough, the entrance aperture to the via being smaller than a region on the substrate on which a feature is to be deposited; and
creating the feature by depositing a material over the covering layer so that the feature is deposited on the surface of the substrate substantially without depositing the material on side walls of the covering layer adjacent the feature.

In a further aspect of the invention there is provided a solid state electrical device having a feature made according to the method aspect of the invention.

In a further aspect of the invention there is provided an intermediate product of a method for depositing a feature during a device fabrication process, the product comprising
a substrate layer onto which a feature is to be created;
a covering layer above the substrate layer and having a void therein which the feature is to exist; and,
a surface inhibition layer having an aperture extending therethrough, the aperture having a lateral dimension smaller than the corresponding lateral dimension of the void.

The feature can be of a metal. Preferred metals include gold, titanium, platinum and combinations thereof. The feature can be a track, posts or gate finger. The metal can be deposited by evaporation.

The aperture can be formed by overhangs of a surface part of the layer extending beyond lower sidewall parts of the layer. An overhang can be provided on each or either side of the aperture. The lower sidewall parts can be substantially vertical relative to the plane of the substrate.

The surface inhibition layer can be an integral part of the layer. The layer can be of positive or negative photoresist material.

The aperture can be defined by an irradiation step using a mask subsequent to forming the surface inhibition layer. The aperture can be defined by an aperture in the mask or by a masking part of a mask.

The dimension of the aperture is less than that of the void as defined by the side walls of the intermediate layer and so when the feature is created in the void by deposition, the deposited material is shielded from the sidewalls by the edges of the layer defining the aperture. This helps to avoid the formation of defects on the feature.

An embodiment of the invention will now be described, by way of example only, and with reference to the accompanying drawings, in which:

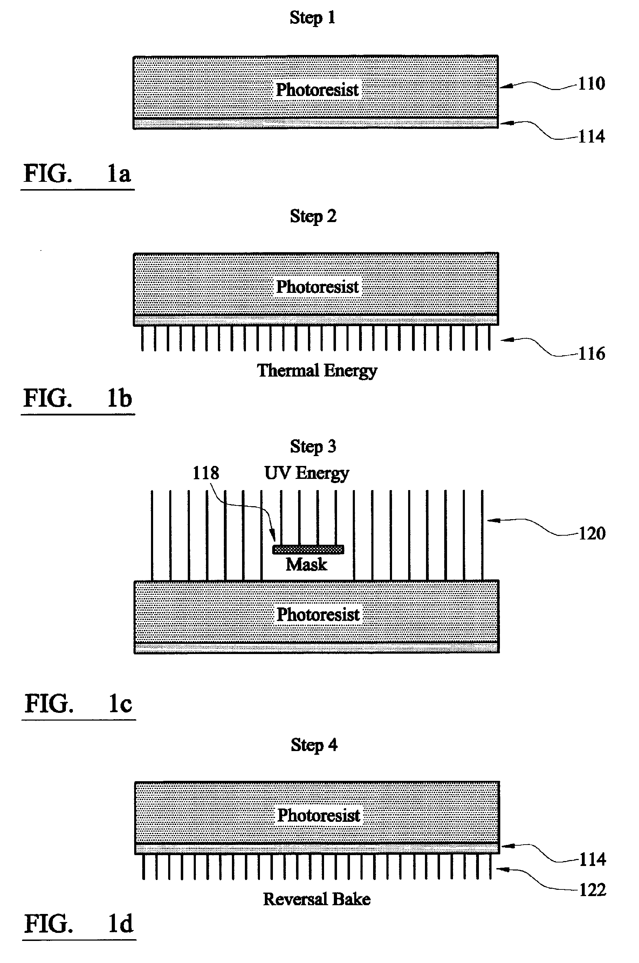

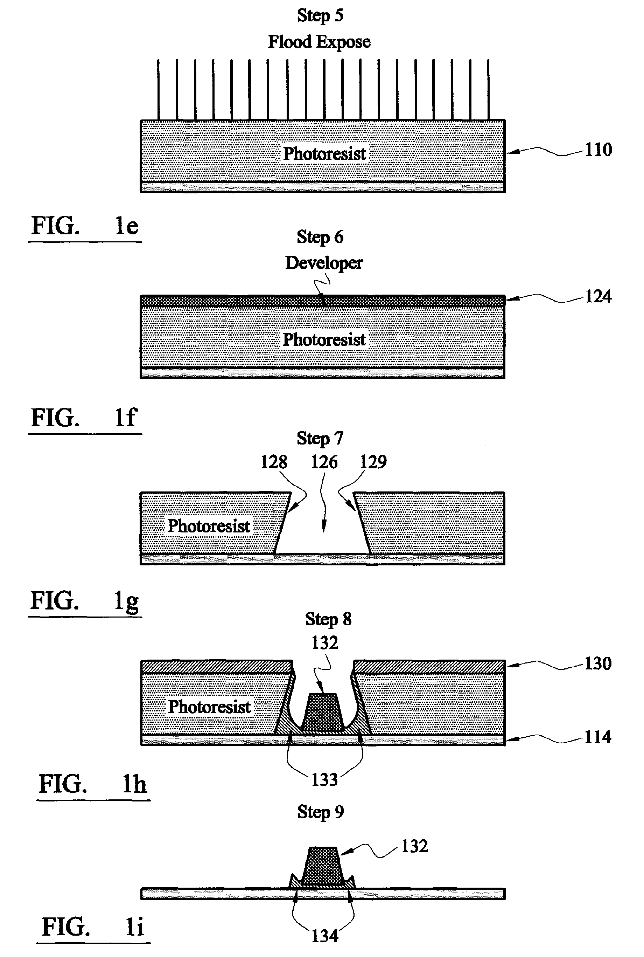

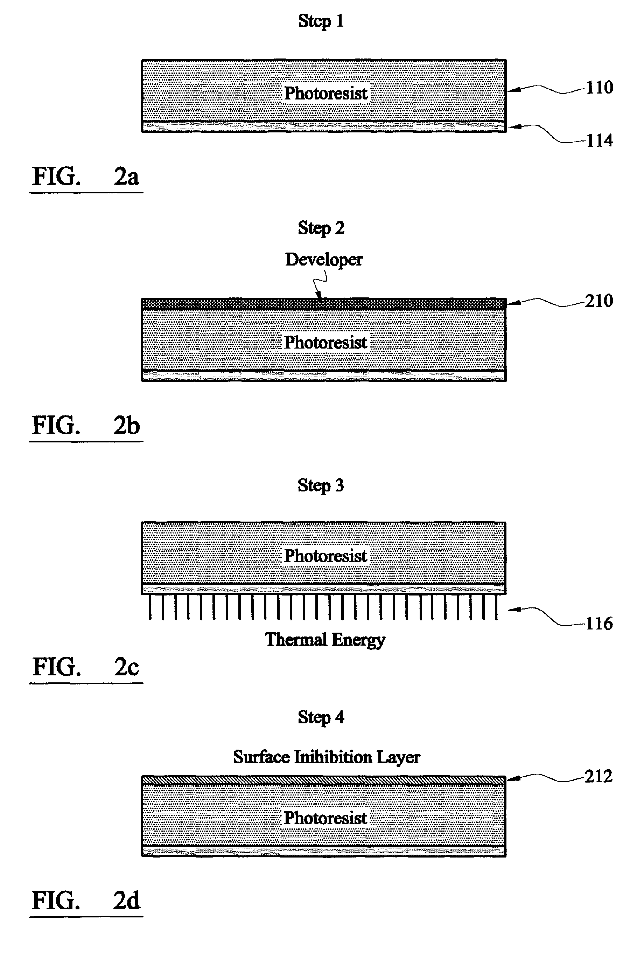

Figures 1a to 1i show schematic diagrams illustrating the steps of a prior art fabrication method; and Figures 2a to 2j show schematic diagrams illustrating the steps of a fabrication method of the present invention.

Similar items in different Figures share common reference numerals unless indicated otherwise.

Figures 1a to 1i illustrate a number of steps of a conventional solid state electronic device fabrication method which will be described by way of background to the present invention.

In a first step a layer of positive photoresist material 110, for example Shipley SPR955CM, is deposited on a substrate 114, which can be Si or GaAs. The substrate is then exposed to thermal energy 116 and heated at a temperature of approximately 120°C for approximately 90 seconds in order to stabilise the solvent content in the resist film 110. In an imaging exposure step illustrated in figure lc, a mask 118 is positioned over an area at which a feature is to be created and the workpiece is exposed to ultraviolet radiation 120 so as to transfer the mask pattern into the photoresist. A typical exposure level is 50mJ/cm².

A reverse side of the substrate 114 is then heated 122 using a hot plate providing a temperature of approximately 115°C for approximately 240 seconds so as to activate a cross-linking agent in the photoresist. An upper surface of the photoresist layer 110 is then exposed to developer solution 124 all over its surface so as to remove the exposed areas of photoresist. This step creates via 126, and the photoresist layer has reentrant or negatively sloped sidewalls 128, 129.

A layer of metal 130 is then deposited using evaporation so as to create the desired metal track feature 132 on the substrate 114. The resist sidewall profile is acceptable in that it allows the photoresist layer to be lifted-off from the substrate in a final lift-off stage to leave the feature 132. However, rotation of the evaporator during the metal deposition stage tends to deposit metal 133 also on the sidewalls 128,129 of the photoresist. This sidewall deposited metal often forms an attachment with the metal track 132. As shown in Fig 1i, after the photoresist layer has been lifted off, metal frill type defects 134 are left on the track.

Figures 2a to 2j illustrate steps in a solid state electronic device fabrication method of the present invention. A number of the method steps are the same as or similar to those of the conventional method described above and so will not be described again in great detail.

Figure 2a shows a wafer substrate 114 on which a feature is to be fabricated and onto which a covering layer of positive photoresist 110 has been spun. Shipley SPR955 is an example of a suitable photoresist material. A softbake step corresponding to Figure 1b is not the next step. Instead, a MIF (Metal Ion Free) developer solution 210, is used to develop the upper surface of the photoresist layer. TMAH ammonium hydroxide is a suitable MIF developer. Alternatively, a MIB (Metal Ion Bearing) developer solution can be used, such as sodium hydroxide. The substrate is then exposed to thermal energy (Fig 2c) in a softbake step using a hotplate to heat the wafer to a temperature of 120°C for approximately 90 seconds so as to create a thin inhibition layer 212 at the upper surface of the photoresist. The inhibition layer is typically approximately 1-3µm thick. The temperature used in, and duration of, this step determines the thickness or depth of the inhibition layer.

An imaging exposure step is then performed (Fig 2e) using ultraviolet radiation 214 and a mask 216 to define an aperture 218 corresponding to an area to be exposed on the inhibition layer which will eventually provide an aperture through which a feature will be formed. The sizing energy Eₛ is increased compared to prior art methods so as to take into account the effect of the inhibition layer. As will be appreciated, the sizing energy is the energy dose required to achieve the mask critical dimension ("CD", i.e. desired size of the feature). For a positive resist process, energy is increased in order to enlarge a resist space and reduced in order to enlarge a resist line. The opposite is the case for a negative resist. A typical sizing energy dose would be 300mJ/cm² for 600ms.

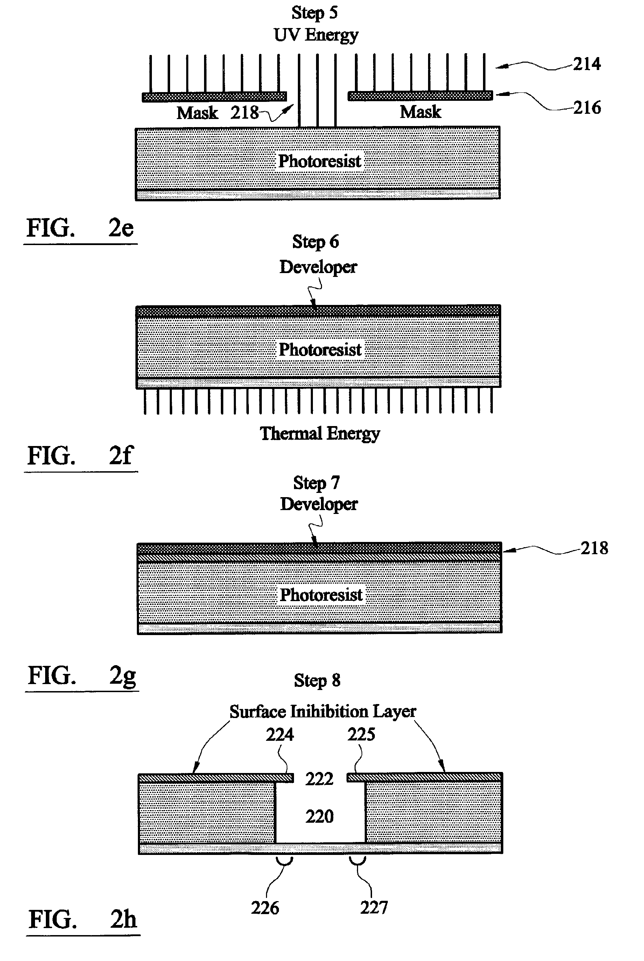

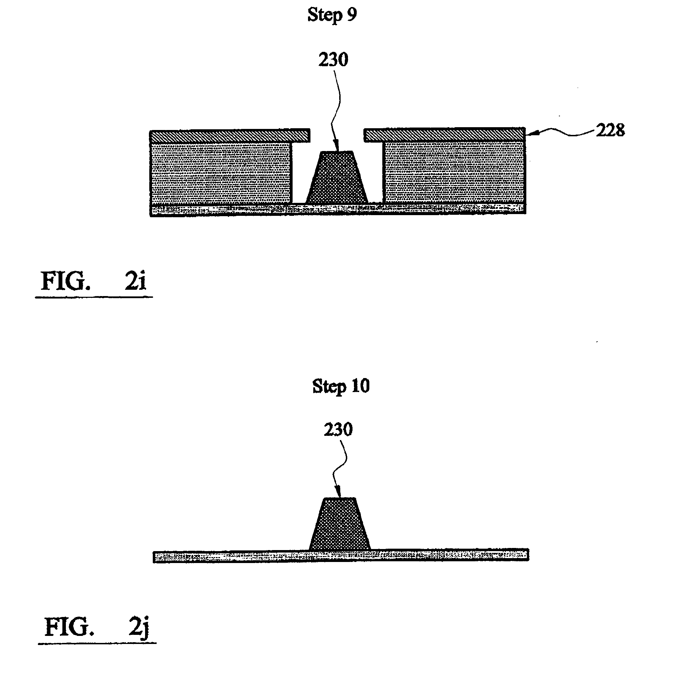

Figure 2f illustrates a post exposure bake step analogous to Figure 1d. A hotplate is used to heat the wafer at a temperature of approximately 130°C for approximately 90 seconds so as to improve resist contrast and reduce standing waves. Increasing the post exposure bake temperature reduces the resist sensitivity and thereby reduces the critical dimension. A developer 218 is then used in a developing step (Fig 2g) to create via 220 and an aperture 222 in the inhibition layer corresponding to the area exposed by mask 216 previously. The inhibition layer has parts overhanging the via. The surface inhibition layer slows the dissolution rate of the developer. Once the inhibition layer has been breached the dissolution of the resist increases, resulting in the overhanging side wall profile.

The lateral dimension of the inhibition layer aperture is less than the lateral dimension of the aperture in the photoresist material and so the overhangs 224,225 generate corresponding 'shadow' regions 226,227 on the exposed upper surface of substrate 114. The resist side walls are close to vertical with respect to the plane of the substrate and this is controlled by the post exposure bake temperature and time which improves the resist contrast performance.

Metal is deposited so as to create the desired feature 230 on the substrate. The end portions of the inhibition layer over hang the sidewalls of the photoresist layer and so help to prevent metal from being deposited on the side walls. The overhang profile prevents metal migrating around the lip of the profile thereby eliminating sidewall deposition and reducing metal defects on the feature after the photoresist layer is lifted-off.

The techniques and materials used in a number of the individual steps of the method are considered to be generally known to those of ordinary skill in this art and so have not been described in great detail. However, the details, and particular combination and sequence, of steps used to provide the overhang resulting in an improved lift-off profile, and providing such an improved lift-off profile, are not.

As will be appreciated by those of skill in the art there are a number of other combinations and sequences of method steps which could be used to provide an improved lift-off profile according to the invention and the above is to be considered a preferred example only.

## Claims

1. A method for depositing a feature on a substrate during a device fabrication process, the method comprising the steps of
providing a substrate;
providing a covering layer on the substrate;
providing a surface inhibition layer on the substrate;
providing an aperture extending through the surface inhibition layer;
providing a via extending from the aperture through the covering layer to the substrate, the via being larger then the aperture such that the surface inhibition layer overhangs the via;
depositing a feature material through the aperture onto the substrate to form the feature.

2. A method as claimed in claim 1, wherein the covering layer is a photoresist.

3. A method as claimed in either of claims 1 or 2, wherein the step of providing a surface inhibition layer comprises the steps of applying a developer to the top surface of the covering layer remote from the substrate; and
subsequently heating the covering layer.

4. A method as claimed in any one of claims 1 to 3, wherein the steps of providing the aperture and the via comprise the steps of
providing a mask;
irradiating the surface inhibition layer through an aperture in the mask;
applying a developer to remove the irradiated portion of the surface inhibition layer to define the aperture and to remove the covering layer to define the via, the developer having a lower dissolution rate in the surface inhibition layer than in the covering layer.

5. A method as claimed in any one of claims 1 to 4, wherein the via extends through the covering layer substantially normal to the substrate, the via being of uniform cross section along its length.

6. A method as claimed in claim 5, wherein at least one lateral dimension of the aperture is less then the corresponding lateral dimension of the via.

7. A method for depositing a feature on a substrate during a device fabrication process, the method comprising the steps of:
providing a substrate;
proving a covering layer on the substrate, the covering layer having a via extending therethrough, the entrance aperture to the via being smaller than a region on the substrate on which a feature is to be deposited; and
creating the feature by depositing a material over the covering layer so that the feature is deposited on the surface of the substrate substantially without depositing the material on side walls of the covering layer adjacent the feature.

8. A solid state electrical device having a feature made according to the method of any preceding claim.

9. An intermediate product of a method for depositing a feature during a device fabrication process, the product comprising
a substrate layer onto which a feature is to be created;
a covering layer above the substrate layer and having a void therein which the feature is to exist; and,
a surface inhibition layer having an aperture extending therethrough, the aperture having a lateral dimension smaller than the corresponding lateral dimension of the void.
